# EUROPÄISCHE PATENTSCHRIFT

(11) **EP 0 397 976 B1**
(45) Veröffentlichungstag und Bekanntmachung des Hinweises auf die Patenterteilung: **18.09.1996**
(21) Anmeldenummer: 90104496.6
(22) Anmeldetag: 09.03.1990
(51) Int. Cl.: C08J 5/24, C08L 63/00, C08G 59/40, H05K 1/03, B32B 5/22, B32B 27/04, B32B 31/20

(54) **Verfahren zur Herstellung von Verbundwerkstoffen**
Method for making composite materials
Procédé de fabrication de matières composites

(30) Priorität: 16.05.1989 DE 3915823
(43) Veröffentlichungstag der Anmeldung: 22.11.1990
(73) Patentinhaber: Bakelite AG, 58642 Iserlohn-Letmathe (DE)
(72) Erfinder: Jellinek, Karl, Dr., D-5860 Iserlohn (DE); Meier, Berthold, Dr., D-5750 Menden (DE); Duda, Horst, D-5860 Iserlohn (DE); Reisel, Winfried, D-5860 Iserlohn (DE)

(56) Entgegenhaltungen:
- EP-A- 0 138 609
- EP-A- 0 293 544
- DE-A- 3 700 287
- US-A- 4 343 843
- WORLD PATENTS INDEX LATEST No. 89-051341 (07) Derwent Publications Ltd., London GB & JP-A-64001753 (MATSUSHITA ELEC.WORKS) 06-01-89
- WORLD PATENTS INDEX LATEST No. 87-166793 (24) Derwent Publications Ltd., London GB &JP-A-62098793 (MITSUBISHI GAS CHEM.KK) 08-05-87
- WORLD PATENTS INDEX LATEST No. 89-051343 (07) Derwent Publications Ltd., London GB & JP-A-64001755 (MATSUSHITA ELEC.WORKS) 06-01-89
- PATENT ABSTRACTS OF JAPAN C-467 08-01-88 && JP-A-62161839 (HITACHI CHEM. CO.LTD.) 17-07-87

## Beschreibung

Die Erfindung betrifft ein Verfahren zur kontinuierlichen Herstellung von Verbundwerkstoffen, insbesondere Leiterplatten auf der Basis von Epoxidharz-Laminaten in einer Doppelbandpresse.

Verbundwerkstoffe sind flächige Gebilde aus mindestens zwei Lagen miteinander verbundener Laminate und/oder Folien. Leiterplatten sind Verbundwerkstoffe, bei denen ein Laminat ein- oder beidseitig mit einer Metall-, insbesondere mit einer Kupferfolie verbunden ist.

Zur Herstellung dieser Laminate werden poröse Materialien, insbesondere Glasgewebe wie z. B. US Style 7628 mit 200 g/m² Flächengewicht mit 40 bis 45 % eines duroplastischen Harzes vorzugsweise mit einem Bindemittel auf Basis eines Epoxidharzes beharzt. Dies geschieht überlicherweise durch Imprägnieren des Glasgewebes mit einer entsprechenden Harzlösung und durch Trocknen des sogenannten Prepregs auf einen definierten Vorhärtungsgrad. Die so hergestellten Laminate werden überlicherweise geschnitten, übereinander geschichtet und mit Kupferfolie zwischen Edelstahlblechen in Mehrlagenpressen unter Druck und Temperatur ausgehärtet. Dabei werden an die Härtungsgeschwindigkeit keine besonderen Anforderungen gestellt.

Anders ist dies bei einer kontinuierlichen Herstellung in einer Doppelbandpresse, bei der die Verbundwerkstoffe, insbesondere Leiterplatten mit einer Geschwindigkeit von bis zu 8 m/min gefertigt werden. Hier ist eine sehr hohe Beschleunigung des Härtungssystems erforderlich.

Aus DE-A 37 14 997 ist ein entsprechendes Bindemittel bekannt, das aus Epoxidharzen, Cyanamid und dem Beschleuniger 2-Methylimidazol besteht. Dieses Bindemittel ergibt mit Glasgewebe Laminate mit ausgezeichneten physikalischen und chemischen Eigenschaften. Die als Zwischenstufe in der Laminatherstellung erhaltenen, mit Harz vorimprägnierten, aber noch fließfähiger Gewebebahnen, sogenannte Prepregs verfügen in der Heißpresse zwar über eine sehr rasche Aushärtung; sie sind jedoch bei Raumtemperatur nur wenig lagerfähig und härten meist nach wenigen Tagen aus. Ihr Transport vom Prepreghersteller zum Hersteller der Leiterplatten ist daher praktisch kaum möglich. Außerdem läßt die Haftung der mit aufgepreßten Kupferfolie zu wünschen übrig.

Es ist daher Aufgabe der Erfindung, ein Verfahren zur kontinuierlichen Herstellung von Verbundwerkstoffen bereitzustellen, bei dem die ensprechenden Prepregs sehr gute Laminateigenschaften ergeben, sehr schnell aushärten und somit die kontinuierliche Herstellung in Doppelbandpressen ermöglichen, aber andererseits bei Raumtemperatur ausreichend lagerstabil sind, so daß sie ohne Qualitätsverlust gelagert werden können.

Die Lösung der Aufgabe erfolgt durch ein Verfahren gemäß der Ansprüche 1 bis 5.

Es wurde gefunden, daß durch Einsatz von Laminaten, die durch Imprägnieren eines porösen Trägermaterials mit einem Bindemittel aus einem Epoxidharz, einem Novolak auf Basis eines Bisphenols und 0,4 bis 2,0 Gew.-%, bezogen auf das Gesamtbindemittel eines Imidazols aus der Gruppe Imidazol, 2-Phenyl-, 2-Methyl-, 1-Methyl- und 2-Ethyl-4-methylimidazol hergestellt werden, alle oben aufgezählten Anforderungen erfüllt werden.

Laminate, die durch Imprägnieren eines porösen Trägermaterials mit einem Bindemittel aus einem Epoxidharz, einem Novolak auf Basis eines Bisphenols und einem Imidazol als Beschleuniger sind aus US-PS 4,501,787 bekannt. Die Imidazole werden hier in geringen Mengen von 0,15 bis 0,21 %, bezogen auf die Summe von Bindemittel und Lösemittel oder Flammschutzmittel zugegeben, d.h., in einer Menge, die ausreicht, um bei einer normalen Aushärtung der Verbundwerkstoffe in einer Etagenpresse eine gute Durchhärtung zu erzielen, aber gleichzeitig noch eine gute Lagerstabilität zu behalten. Entsprechende Harzmischungen sind für eine kontinuierliche Harzherstellung nicht geeignet.

Es wurde gefunden, daß bei einer wesentlichen Erhöhung des Imidazolanteils auf 0,4 bis 2 %, bevorzugt auf 0,5 bis 1 Gew.-%, bezogen auf das Gesamtbindemittel, die Härtungsgeschwindigkeit überproportional gesteigert wird. Während eine Erhöhung der Härtungsgeschwindigkeit - wenn auch nicht in diesem Maße - vom Fachmann durchaus erwartet werden konnte, ist es überraschend, daß trotz erhöhter Reaktivität des Bindemittels die Lagerstabilität nicht wesentlich beeinflußt wird. Das heißt, sowohl im Imprägnierbad als auch bei den imprägnierten Laminaten wird keine vorzeitige Aushärtung des Bindemittels beobachtet. Die Prepregs sind bei Raumtemperatur bis zu 3 Monaten lagerfähig, ohne daß durch eine partielle Weiterhärtung des Bindemittels ein Qualitätsverlust eintritt. Die fertigen Verbundwerkstoffe weisen bei der späteren Bohrung, Ätzung und Durchkontaktierung in elektrolytischen Bädern keinerlei Verfärbung und störende Harzreste in den Bohrlöchern auf. Die Haftung der Metallschichten an den Bohrlochwandungen erweist sich als völlig einwandfrei.

Als Epoxidharz eignen sich alle handelsüblichen Epoxidharze, wie sie z. B. auch in dem Lehrbuch Handbook od Epoxy Resins von Lee und Neville aufgeführt sind. Für viele Anwendungen werden flammfeste Verbundwerkstoffe gemäß NEMA-Spezifikation FR IV bevorzugt.

Als geeignete Imprägnierlösungen eignen sich solche auf Basis der an sich bekannten durch Kettenverlängerung von Bisphenol A-Diglycydylether mit Tetrabrombisphenol und/oder Bisphenol A erhalten oligomeren Harze mit Epoxidäquivalenten von 250 bis 500 g/Äquivalent, bevorzugt von 250 bis 450 g, bezogen auf den Festharzgehalt.

Als Härterkomponente werden Novolakharze von ausgewählten Bisphenolen verwendet, die durch Polykondensation mit Formaldehyd im Molverhältnis von 1 zu 0,5 bis 0,95 unter Verwendung von üblichen sauren Kondensationskatalysatoren wie z. B. Oxalsäure, Phosphorsäure oder Schwefelsäure hergestellt werden.

Geeignete Bisphenole zur Herstellung von Novolakharzen, die als Härterkomponenten im Rahmen der vorliegenden Erfindung Verwendung finden, haben sich folgende Verbindungen erwiesen:

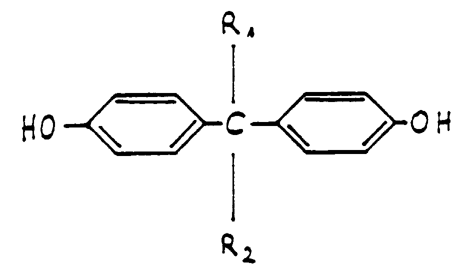

Wobei R₁ und R₂ gleich oder verschieden sein können und die Reste CH₃-, C₂H₅-, C₃H₇- oder C₄H₉- bedeuten können. Die Menge an eingesetzem Bisphenol-Novolak liegt im Bereich von 5 bis 40 Gew.-%, bezogen auf das Gesamtbindemittel , wobei bei höheren Epoxidharzäquivalentgewichten geringere Mengen Novolak gewählt werden.

Die vorgenannten Mischungen aus den oligomeren Epoxidharzen und den Bisphenolnovolakharzen werden mit 0,5 bis 1,5, bevorzugt 0,6 bis 0,8 Gew.-% (bezogen auf das gesamte Bindemittel) an Imidazolen hoch reaktiv eingestellt. Vorzugsweise wird so stark beschleunigt, daß Gelierzeiten (sogenannte B-Zeiten) auf der flachen Platte bei 170 °C von 50 bis 170 Sekunden resultieren. Die Lagerstabilität der Imprägnierflotte bei üblichen Imprägnierbedingungen bis z. B. 40 °C beträgt dabei mindestens 5 Tage.

Als Imidazolverbindungen werden die bekannten Imidazole eingesetzt, wie Imidazol, 2-Phenylimidazol, 2-Methylimidazol, 1-Methylimidazol, 2-Ethyl-4-methylimidazol.

Ein weiteres Erfindungsmerkmal dieser mit Bisphenolnovolakharzen gehärteten oligomeren, meist flammenhemmend eingestellten Epoxidharzen zeigt sich bei der Weiterverarbeitung der kupferkaschierten Leiterplatten. Die erfindungsgemäßen Systeme zeigen völlig überraschend ein wesentlich günstigeres Verhalten beim Bohren und Durchkontaktieren der entstehenden Bohrlöcher nach dem vorangegangenen Ätzprozeß.

Hierbei tritt weder die sonst so unerwünschte Verfärbung der Leiterplatten, noch die sonst häufig anzutreffenden Schwierigkeiten der restlosen Entfernung von überwiegend gelartig aufgequollenen Bohrstäuben (Smear) auf. Die Bohrstaubentfernung ist bei den mittels der erfindungsgemäßen Bindemittelkombinationen hergestellten Leiterplatten ohne anhaftende Gelteilchen auf den Bohroberflächen völlig problemlos möglich und führt sofort zu glatten Bohrlochoberflächen, wodurch eine einwandfreie Durchkontaktierung ermöglicht wird.

Die erfindungsgemäß einzusetzenden Bindemittel können sowohl als 50 bis 90 %ige Lösungen auf normalen Imprägnieranlagen, oder auch als sogenannte High-Solid-Systeme mit Festkörperanteilen von 90 bis 99,5 % bzw. auch als Feststoffmischungen gegebenenfalls unter Zusatz bis zu 8 % Lösungsmittel auf Schmelzwalzen, Schmelzkalandern oder Tapeanlagen zu Glasgewebe-Prepregs verarbeitet werden.

### Beispiele

In den Beispielen 1 bis 12 werden Harzlösungen mit unterschiedlichen Harzen und unterschiedlichen Beschleunigeranteilen hergestellt. Prozentangaben bedeuten dabei Gewichtsprozente. Die Beispiele 1 bis 3 sind erfindungsgemäß, die Beispiele 4 bis 12 Vergleichsbeispiele.

Die Verarbeitbarkeitszeit der Harze wird dadurch bestimmt, daß jeweils 10 l der Harzlösung bei 25 °C gelagert werden, wobei jeden Tag geprüft wird, ob sich die Lösung noch zur Imprägnierung von Glasgewebe eignet oder ob sie bereits zu stark gealtert ist.

Die Ergebnisse finden sich in Tabelle I.

Darüberhinaus werden die sogenannten B-Zeiten bei 170 °C und 150 °C nach folgendem Verfahren gemessen:

1 ml der Harmischung wird nach der Mischung (nach 15 min bzw. 25 min) auf die flache Heizplatte gegeben. Mit einem Glasstab wird unter einem Winkel von 60 Grad so lange gerührt bis das Harz geliert ist und beim Anheben des Glasstabes abreißt. Die Zeit von der Aufgabe der Harzlösung bis zum Gelierpunkt wird festgehalten und als B-Zeit eingetragen.

Die erhaltenen Werte finden sich in Tabelle II.

### Beispiel 1

Es wird eine Harzlösung hergestellt mit einem Feststoffgehalt von 75 % in einem Gemisch aus Methylethylketon und 1-Methoxypropanol-2 (1 : 1). Gelöst werden 78 eines Epoxidharzes auf Basis Bisphenol A und Tetrabrombisphenol A mit einem Epoxidäquivalent von 320 und einem Bromgehalt von 25 %, sowie 22 % eines Novolaks auf Basis Bisphenol A mit einem molaren Verhältnis von Bisphenol A zu Formaldehyd von 1 : 0,7 hergestellt durch saure Kondensation. Die Lösung wird mit 0,5 % 2-Ethyl-4-methylimidazol, bezogen auf den Festharzanteil, versetzt und mit Methylethylketon auf einen Harzgehalt von 58 % verdünnt.

### Beispiel 2

Lösung gemäß Beispiel 1, jedoch mit einem Gehalt von 1,0 % 2-Ethyl-4-methylimidazol, bezogen auf den Festharzanteil.

### Beispiel 3

Lösung gemäß Beipiel 1, jedoch mit einem Gehalt von 2,0 % 2-Ethyl-4-methylimidazol, bezogen auf den Festharzanteil.

### Beispiel 4

Einer handelsüblichen FR-4-Harzlösung (Rütapox® VE 3579) (Harzgehalt 75 %, Epoxidharz mit einem Epoxidäquivalent von 400 ± 20, einem Bromgehalt von 20 ± 1 und einer Viskosität bei 25 °C von 500 ± 150 mPa s) werden 3 % Dicyandiamid in Form einer 10 %igen Lösung in Methylglykol bezogen auf den Festharzgehalt der Harzlösung als Härter zugesetzt. Es werden 0,5 % 2-Ethyl-4-methylimidazol, bezogen auf den Festharzgehalt zugegeben und mit Methylethylketon auf einen Harzgehalt von 58 % verdünnt.

### Beispiel 5

Lösung gemäß Beispiel 4, jedoch mit einem Gehalt von 1,0 % 2-Ethyl-4-methylimidazol, bezogen auf den Festharzanteil.

### Beispiel 6

Lösung gemäß Beispiel 4, jedoch mit einem Gehalt von 2,0 % 2-Ethyl-4-methylimidazol, bezogen auf den Festharzanteil.

### Beispiel 7

Lösung gemäß Beispiel 1, jedoch mit einem Gehalt von 0,5 % Benzyldimethylamin (BDMA) anstelle des Imidazols.

### Beispiel 8

Lösung gemäß Beispiel 7, jedoch mit einem Gehalt von 1,0 % BDMA.

### Beispiel 9

Lösung gemäß Beispiel 7, jedoch mit einem Gehalt von 2,0 % BDMA.

### Beispiel 10

Lösung gemäß Beispiel 4, jedoch mit einem Gehalt von 0,5 % BDMA anstelle des Imidazols.

### Beispiel 11

Lösung gemäß Beispiel 10, jedoch mit einem Gehalt von 1,0 % BDMA.

### Beispiel 12

Lösung gemäß Beispiel 10, jedoch mit einem Gehalt von 2,0 % BDMA.

**Tabelle I**

| Beispiel | Ende der Verarbeitbarkeitszeit nach [d] |
|---|---|
| 1 | 21 |
| 2 | 20 |
| 3 | 12 |
| 4 | 5 |
| 5 | 3 |
| 6 | 3 |
| 7 | 6 |
| 8 | 4 |
| 9 | 3 |
| 10 | 5 |
| 11 | 3 |
| 12 | 2 |

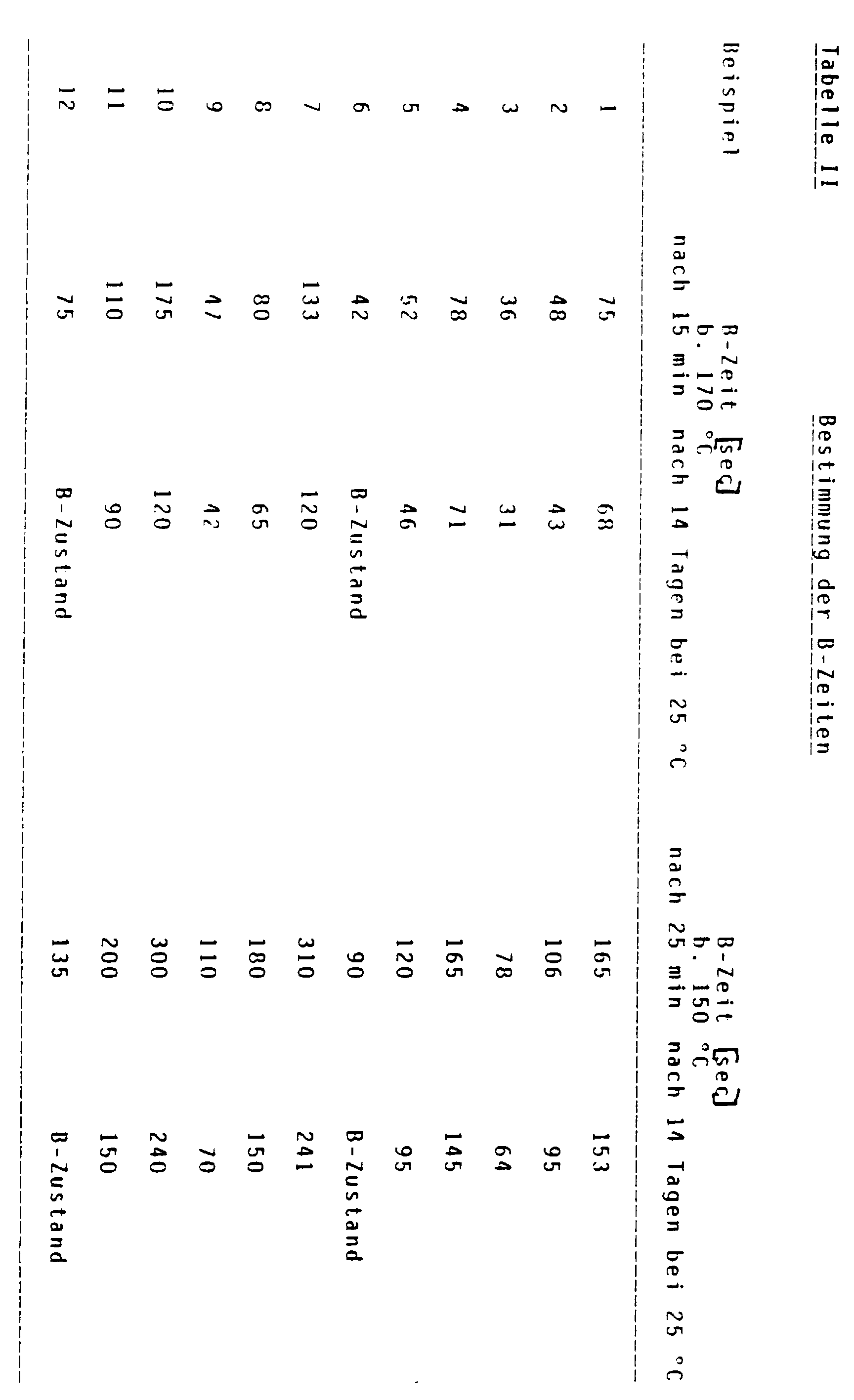

### Beispiel 13

Mit den in den Beispielen 1 bis 3 aufgeführten Lösungen (Imprägnieransätze) wird Glasgewebe Typ US-Style 7628 mit Finish Z 6040 beharzt und im Trockenofen getrocknet. Der Harzgehalt beträgt 40 bis 45 %. Der Harzfluß beträgt 8 bis 10 %. 8 Lagen des beharzten Gewebes werden in einer Presse 60 min bei 170 °C unter Druck zu einem Verbundwerkstoff verpreßt. Die auf diese Weise erhaltenen Laminate werden hinsichtlich ihrer für die Elektrikanwendung relevanten physikalischen Eigenschaften überprüft. Die gemessenen Werte zeigt die Tabelle III.

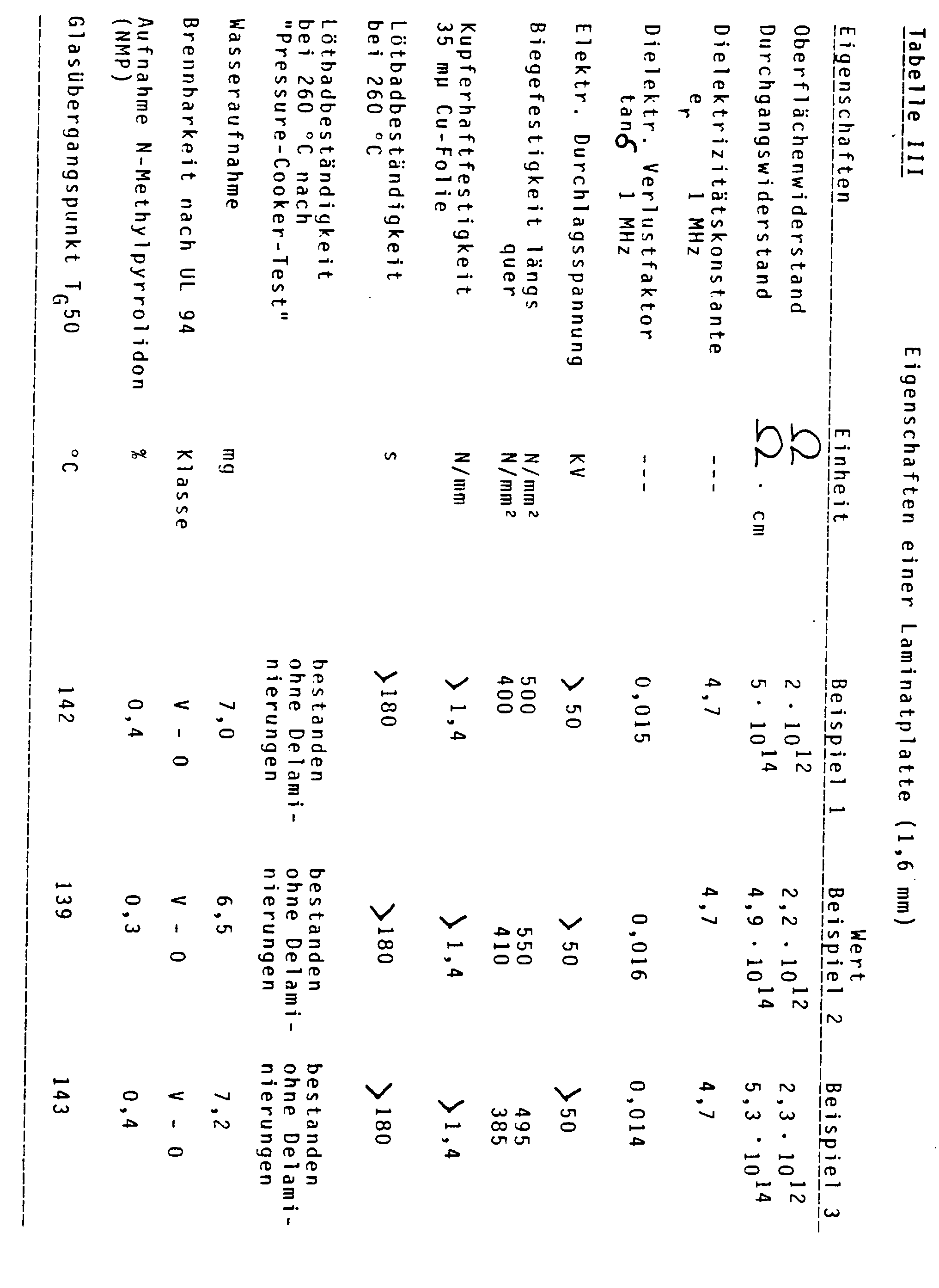

### Beispiel 14

Analog zu Beispiel 13 werden mit den in den Beispielen 4 bis 6 hergestellten Lösungen (Imprägnieransätzen) Laminate hergestellt und untersucht. Die erhaltenden Werte finden sich in Tabelle IV.

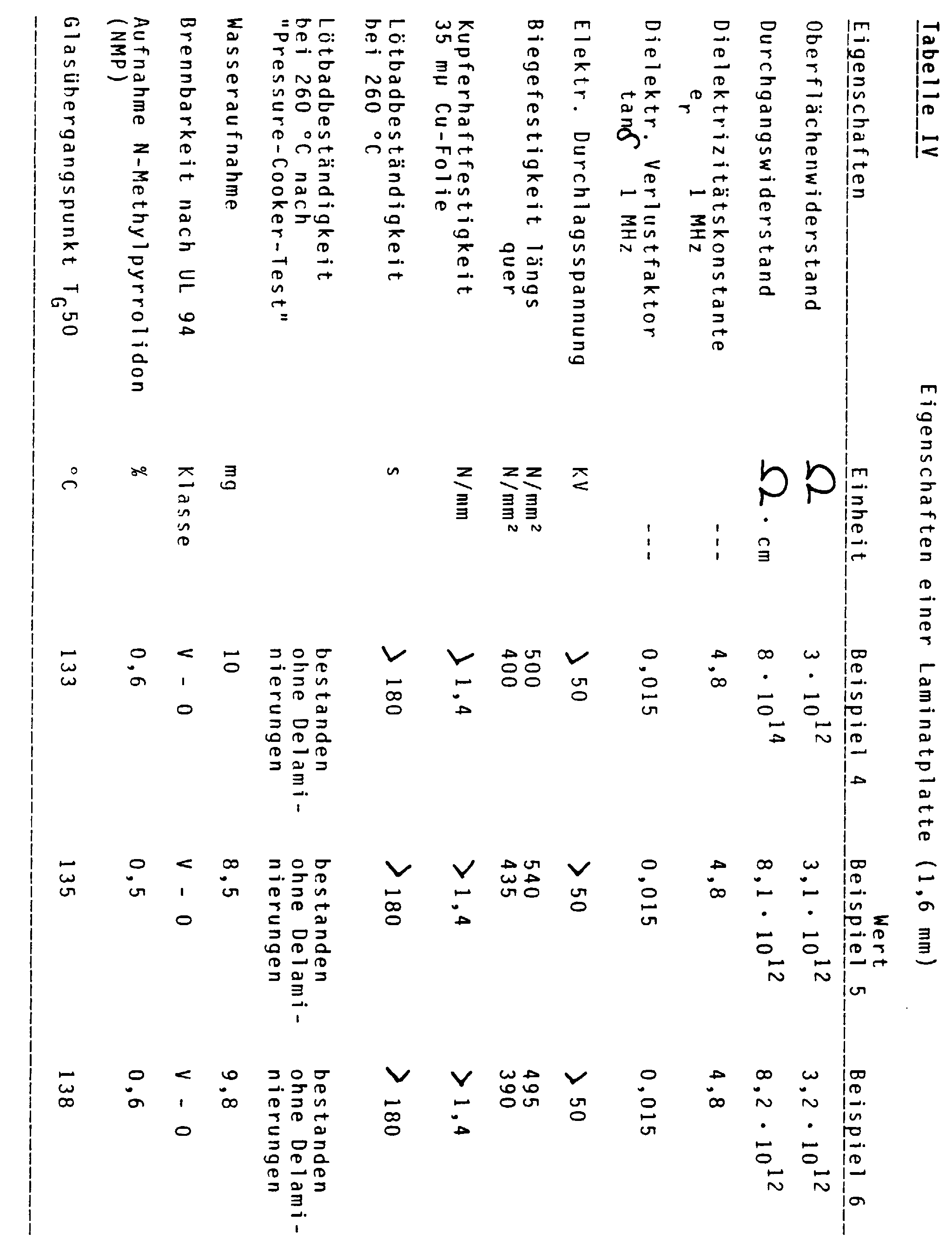

## Patentansprüche

1. Verfahren zur kontinuierlichen Herstellung von Verbundwerkstoffen auf der Basis von Epoxidharz-Laminaten in einer geheizten Doppelbandpresse, **dadurch gekennzeichnet**, daß Prepregs eingesetzt werden, die durch Imprägnieren eines porösen Trägermaterials mit einem Bindemittel aus einem Epoxidharz, einem Novolak auf Basis eines Bisphenols und 0,4 bis 2,0 Gew.-%, bezogen auf das Gesamtbindemittel eines Imidazols aus der Gruppe Imidazol, 2-Phenyl-, 2-Methyl-, 1-Methyl- und 2-Ethyl-4-methylimidazol hergestellt werden.

2. Verfahren nach Anspruch 1, **dadurch gekennzeichnet**, daß das Bindemittel 0,7 bis 1 Gew.-% eines Imidazols enthält.

3. Verfahren nach den Ansprüchen 1 und 2, **dadurch gekennzeichnet**, daß das Bindemittel 5 bis 40 Gew.-% Novolak auf Basis eines Bisphenols enthält.

4. Verfahren nach den Ansprüchen 1 bis 3, **dadurch gekennzeichnet**, daß als Verbundwerkstoffe Leiterplatten hergestellt werden.

5. Verfahren nach den Ansprüchen 1 bis 4, **dadurch gekennzeichnet**, daß die kontinuierliche Laminatherstellung bei Temperaturen von 170 bis 230° C, vorzugsweise von 190 bis 220° C erfolgt.

## Claims

1. A process for the continuous production of composites on the basis of epoxy resin laminates in a heated twin-belt press, characterised in that prepregs are used which are prepared by impregnating a porous carrier material with a binder comprising an epoxy resin, a bisphenol-based novolak and 0.4 to 2.0 wt.% - in relation to the total binder - of an imidazole selected from the group imidazole, 2-phenyl-, 2-methyl-, 1-methyl- and 2-ethyl-4-methylimidazole.

2. A process according to claim 1, characterised in that the binder contains 0.7 to 1 wt.% of an imidazole.

3. A process according to claims 1 and 2, characterised in that the binder contains 5 to 40 wt.% of a bisphenol-based novolak.

4. A process according to claims 1 to 3, characterised in that printed circuit boards are manufactured as composites.

5. A process according to claims 1 to 4, characterised in that the continuous production of laminates takes place at temperatures of 170°C to 230°C, preferably 190°C to 220°C.

## Revendications

1. Procédé pour la fabrication en continu de matériaux composites à base de stratifiés-époxy dans une presse à double bande chauffée, caractérisé en ce que l'on met en oeuvre des préimprégnés qui sont fabriqués par imprégnation d'un support poreux à l'aide d'un liant obtenu à partir d'une résine époxyde, d'une novolaque à base d'un bisphénol et de 0,4 à 2,0% en poids, par rapport au liant total, d'un imidazole du groupe de l'imidazole, des 2-phényl-, 2-méthyl-, 1-méthyl- et 2-éthyl-4-méthyl-imidazoles.

2. Procédé selon la revendication 1, caractérisé en ce que le liant contient 0,7 à 1% en poids d'un imidazole.

3. Procédé selon les revendications 1 et 2, caractérisé en ce que le liant contient 5 à 40% en poids de novolaque à base d'un bisphénol.

4. Procédé selon les revendications 1 à 3, caractérisé en ce qu'en tant que matériaux composites, on confectionne des cartes imprimées.

5. Procédé selon les revendications 1 à 4, caractérisé en ce que la fabrication de stratifiés en continu a lieu à des températures de 170 à 230°C, de préférence de 190 à 220°C.
